# EUROPEAN PATENT SPECIFICATION

(11) **EP 4 055 602 B1**
(45) Date of publication and mention of the grant of the patent: **09.12.2026**
(21) Application number: 20824261.0
(22) Date of filing: 16.12.2020
(51) Int. Cl.: G11C 5/14, H02M 3/07, H03K 17/14

(54) **AUTOMATCH IN OPEN LOOP**
GATE-STEUERUNG FÜR EINEN WECHSELPUMPENWANDLER
ORGANE DE COMMANDE DE GRILLE POUR UN CONVERTISSEUR DE POMPE À CHANGEMENT

(30) Priority: 29.01.2020 EP 20154405; 05.11.2020 WO PCT/EP2020/081170
(43) Date of publication of application: 14.09.2022
(73) Proprietor: EM Microelectronic-Marin SA, 2074 Marin (CH)
(72) Inventor: VENCA, Alessandro, 2068 Hauterive (CH)
(74) Representative: ICB SA
(86) International application number: PCT/EP2020/086554
(87) International publication number: WO 2021/089884

(56) References cited:
- US-A1- 2012 293 893
- US-A1- 2012 293 893

## Description

### Technical field

The present invention relates to the field of open loop control unit and in particular of at least one open loop control unit for UHF RFID passive tags.

### State of the art

In general, in an RFID communication system, the receiving tag antenna may be adapted to maximize the received signal at a specific frequency, i.e. the tuning frequency f₀. The adaptation may be achieved for a specific antenna and tag input impedance.

In this adapted condition, the received power may be maximized, and the Mismatch Loss, ML for short, may be minimized.

Every time the input frequency signal carrier fc differs from f₀, or the tag or antenna impedances differ from the value needed to achieve adaptation the system suffers a loss in the received power.

In operative conditions, the above disrupting scenario may happen for the following reasons:
- The input signal frequency can operate at different frequencies in the UHF RFID band [860-960] MHz;
- Variations in electronic components values due to process or temperature may cause variation in the tag input impedance; and,
- Environmental conditions in which the tag operates, e.g. medium, humidity, temperature, may alter the antenna adaptation.

Therefore, there may be a need to maximize the tag reading distance and this independently of the operative conditions.

The document US 2012/0293893 A1 describes a power source circuit includes a voltage converter circuit and a control circuit that includes a voltage divider circuit and a protective circuit. The protective circuit includes a first oxide semiconductor transistor in which an off-state current is increased as temperature is increased, a capacitor that accumulates the off-state current as electric charge, a second oxide semiconductor transistor, and an operational amplifier including a non-inverting input terminal to which a reference voltage is input. The first oxide semiconductor transistor is provided near the voltage converter circuit or an element that generates heat in the control circuit. But it is not adapted to control an input impedance of a charge pump converter.

### Summary of the invention

In order to achieve this objective, the present invention provides a control system device comprising at least one open loop control unit and at least one charge pump converter. Said open loop control unit is configured to control the efficiency and/or the input impedance of said at least one charge pump converter. Said at least one charge pump converter comprises an input impedance, and a first input impedance controlling terminal. Said open loop control unit comprises at least one:
- reference circuit comprising at least one main reference configured to be constant over time and temperature, and at least one auxiliary reference configured to vary over time and temperature; said reference circuit being configured to sense difference between said main reference and said auxiliary reference such as to transmit a difference value as a function of the temperature and/or the time;
- control unit being configured to receive said difference value, to establish a trim value and to send said trim value to said first input impedance controlling terminal such as to modify said input impedance.
The first input impedance controlling terminal is configured to be plugged to said open loop control unit and to modify said input impedance according to a signal from said open loop control unit. The charge pump converter comprises at least one primary gate controller having at least one primary switching element with first specifications and at least one secondary gate controller having at least one secondary switching element with second specifications. The primary gate controller comprises primary bias input having a primary bias current flow controller and the secondary gate controller comprises a secondary bias input having a secondary bias current flow controller. Said primary bias current flow controller and said secondary bias current flow controller being configured to be plugged to said open loop control unit to receive said trim value via the first input impedance controlling terminal and to modify the input impedance.

This configuration allows determining the received power and take actions to minimize the tag sensitivity and thus maximize the tag reading distance.

According to a specific aspect of the invention, said difference value comprises a voltage difference value and/or current difference value.

According to an embodiment, said voltage difference value and/or said current difference value may be or may be analog signal.

Thus, the transmission of said difference value as a function of the temperature and/or the time may be quicker than digital signal.

According to a specific aspect of the invention, said at least one auxiliary reference comprises at least one first switching element having first specifications and said charge pump converter comprises at least one primary switching element and at least one secondary switching element having second specifications; a ratio between said first specifications and said second specifications may be comprised between 0.8 and 1.25, preferably between 0.9 and 1.11.

According to a specific aspect of the invention, said first specifications and said second specification may be configured to vary over time and temperature.

According to a specific aspect of the invention, said at least one main reference may be configured to set a reference value and said at least one auxiliary reference may be configured to supply a variable value; said reference value may be constant over time and temperature and said variable value varies over time and temperature.

According to a specific aspect of the invention, said at least one reference circuit comprises at least one at least one comparison circuit configured to compare said reference value to said variable value.

According to a specific aspect of the invention, said at least control unit comprises at least one controller configured to establish an established voltage value and/or an established current value as a function of said difference between said at least one main reference and said at least one auxiliary reference.

According to a specific aspect of the invention, said at least bias supplier comprises at least one converter configured to convert said difference between said at least one main reference and said at least one auxiliary reference into a digital voltage value and/or a digital current value.

According to a specific aspect of the invention, said at least one primary gate controller comprises at least one;
- primary signal output configured to be connected to an at least one second primary signal input of a charge pump converter stage and/or a first circuit;
- first primary signal input configured to receive a first control signal;
- primary bias input configured to establish a voltage value and/or a current value of said at least one primary gate controller (200);
- second primary signal input configured to be connected to an at least one primary signal output of a charge pump converter stage and/or to receive said main signal, preferably from an antenna, from an integrated circuit, at least one primary signal and/or from a charge pump converter stage.
Furthermore, the at least one secondary gate controller comprises at least one:
- secondary signal output configured to be connected to an at least one second secondary signal input of a charge pump converter stage and/or a second circuit;
- first secondary signal input configured to receive a second control signal;
- secondary bias input configured to establish a voltage value and/or a current value of said at least one secondary gate controller; and,
- second secondary signal input configured to be connected to an at least one secondary signal output of a charge pump converter stage and/or to receive a main signal, preferably from an antenna, from an integrated circuit, at least one secondary signal and/or from a charge pump converter stage.
said at least one first primary signal input is configured to be connected to said at least one secondary signal output and said at least one first secondary signal is configured to be connected to said at least one primary signal output.

Thanks to the arrangement according to the invention, said control system device allows sensing the received power and take actions to minimize the tag sensitivity and thus maximize the tag reading distance by adjusting the bias voltage of the gate by coupling the gate of the switching element to the output of the previous charge pump converter stage and said at least one bias input, which sets the DC gate's voltage reference bias.

According to a specific aspect of the invention, said at least one primary switching element has a primary conduction path with a first primary terminal and a second primary terminal, and a primary gate configured to control the current flowing through said primary conduction path, said primary conduction path being configured to provide said at least one primary signal; said primary gate is configured to be connected to said at least one first primary signal input and to said at least one primary bias input, and/or wherein said at least one secondary switching element has a secondary conduction path with a first secondary terminal and a second secondary terminal, and a secondary gate configured to control the current flowing through said secondary conduction path, said secondary conduction path being configured to provide said at least one secondary signal; said secondary gate is configured to be connected to said at least one first secondary signal input and to said at least one secondary bias input.

Thanks to the arrangement according to the invention, the charge pump converter stage allows adjusting the bias voltage of the gate by coupling the gate of the switching element to the output of the previous charge pump converter stage and said at least one bias input, which sets the DC gate's voltage reference bias.

According to a specific aspect of the invention,, said primary bias current flow controller comprises a first primary bias current flow element chosen among a transistor or a resistor and at least a second primary bias element chosen among a transistor or a resistor. Said secondary bias current flow controller comprises at least one first secondary bias current flow element chosen among a transistor or a resistor and at least one second secondary bias element chosen among a transistor or a resistor.

According to an embodiment, said at least one charge pump converter comprises at least one first input impedance controlling terminal configured to be plugged to said open loop control unit such as to modify said input impedance.

Thanks to one of those arrangements according to the invention, the conduction path of the switching element may be controlled.

### Brief description of the drawings

The foregoing and other purposes, features, aspects and advantages of the invention will become apparent from the following detailed description of the embodiments, given by way of illustration and not limitation with reference to the accompanying drawings, in which:
- figures 1A and 1B represent at least one open loop control unit **100** linked to a charge pump converter 500 according to the invention;
- figures 2 shows a block diagram;
- figure 3 illustrates a parallel equivalent circuit and a serie equivalent circuit of a charge pump converter 500;
- figures 4A-4G represent a AutoMatch tag performances at *fᵢₙ* = *f*₀;
- figure 5 represents a AutoMatch tag performances at *fᵢₙ* = *f*₀ *- 55MHz;*
- figure 6 illustrates a AutoMatch tag performances at *fᵢₙ* = *f*₀ + *45MHz;* and,

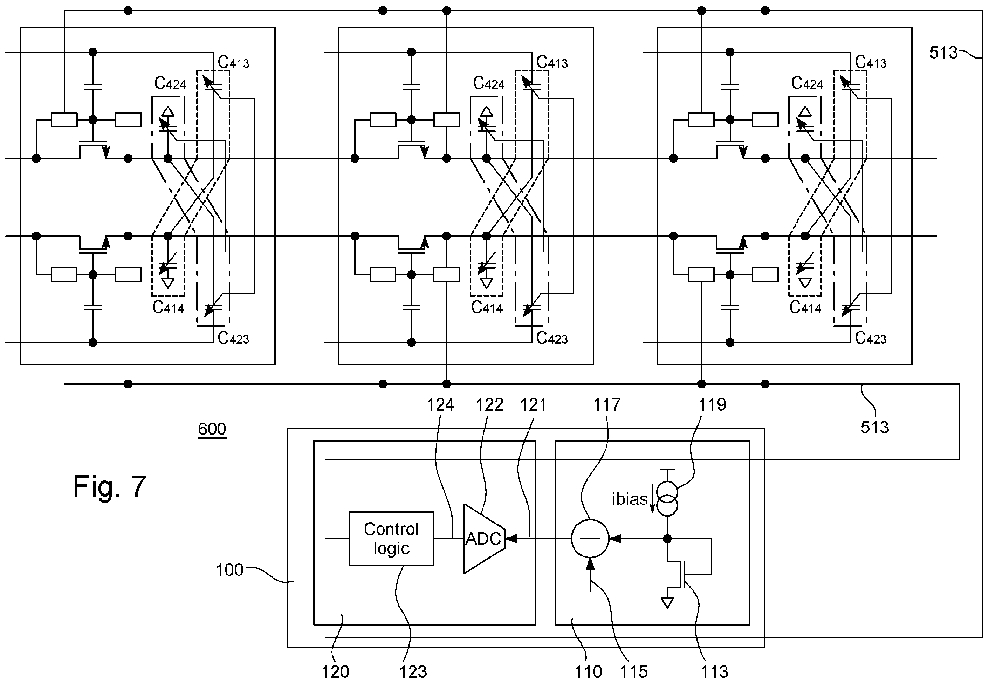

- figure 7 represents a control system device **600** comprising a plurality of charge pump converters **500** and at least one power control unit **100** according to the invention.

### Description of the invention

The present invention relates to at least one open loop control unit **100** configured to determine the output power of a charge pump converter **500** such as to maximize the received signal at a specific frequency, i.e. the tuning frequency f₀.

Indeed, said open loop control unit **100** may be connected to a charge pump converter **500** or Programmable Self-Biased Gate Control **500,** PSBGC **500** for short.

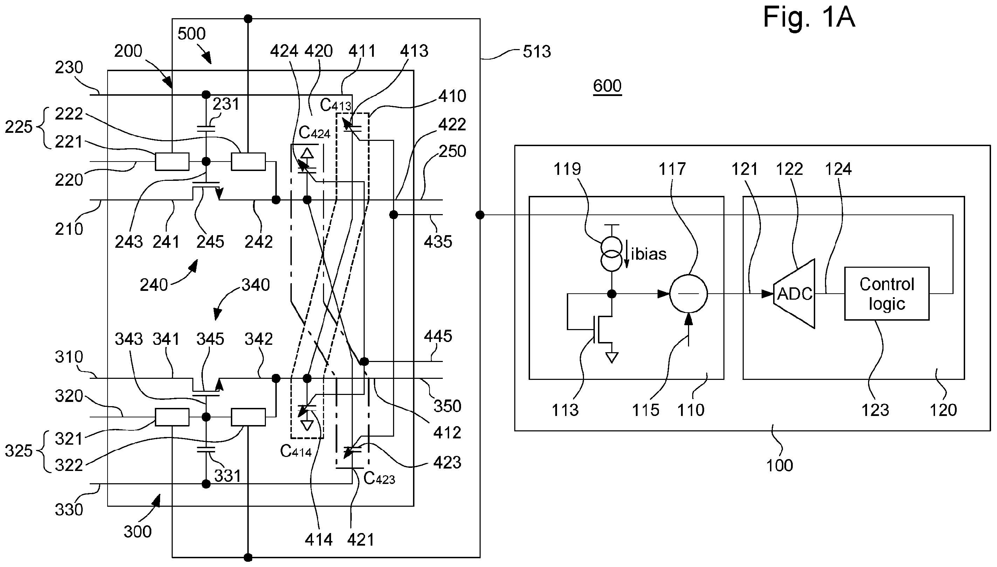

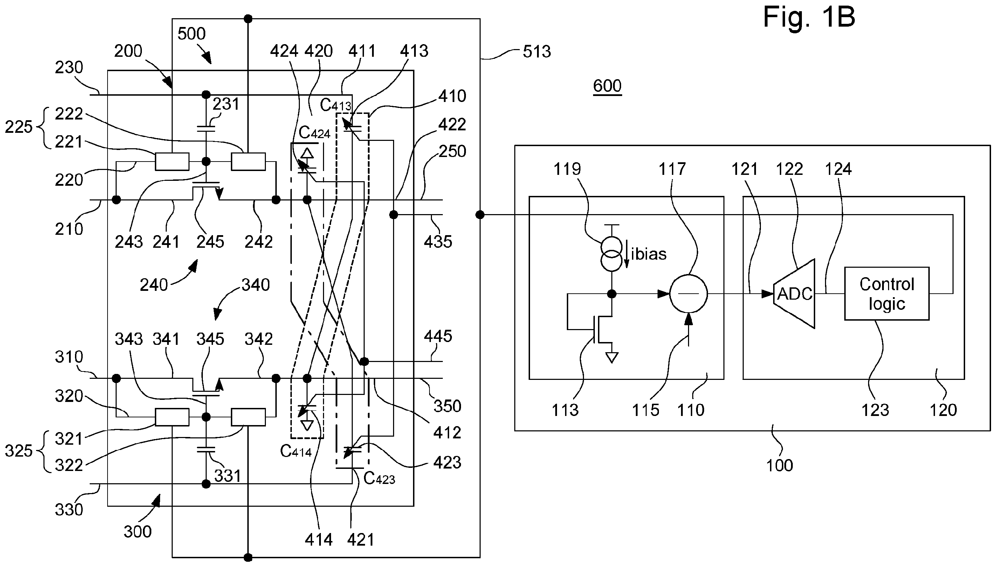

Said Programmable Self-Biased Gate Control **500** or PSBGC **500** may have an input impedance between a first input terminal **210** and a second input terminal **310,** and a first output terminal **350,** a second output terminal **250** and a first input impedance controlling terminal **513,** as illustrated in Figures 1A and 1B.

Said first input impedance controlling terminal **513** may be configured to be plugged to said open loop control unit **100** and to modify said input impedance according a signal from said open loop control unit **100.**

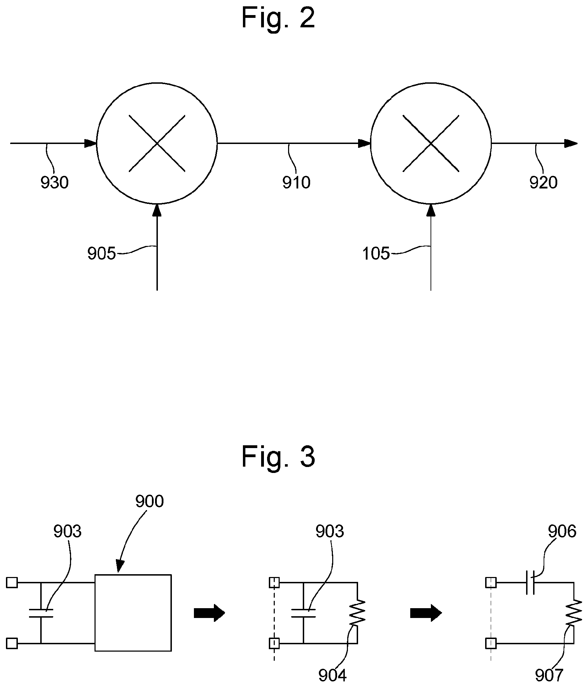

Effectively, to maximize the received power, *Pᵢₙ* **910** for short, it may be necessary but not yet enough condition to maximize the load power, i.e. the rectifier output power, *Pₒᵤₜ* **920** for short, and in order to maximize the load power it may be necessary to maximize also the rectifier efficiency, *eff* **105** for short, see fig. 2.

The relation between the power available at the antenna, *Pₐᵥₐᵢₗ* **930** for short, and the load power, *Pₒᵤₜ* for short, being: ${P}_{out} = {P}_{avail} ∗ \frac{eff}{ML}$ where $eff = \frac{{P}_{out}}{{P}_{in}} and ML = \frac{{P}_{avail}}{{P}_{in}}$

The mismatch loss, *ML* **905** for short, can be expressed in terms of the series impedances of antenna and tag as: $\frac{1}{ML} = \frac{4 {R}_{a} {R}_{ts}}{{\left({R}_{a}+{R}_{ts}\right)}^{2} + {\left({X}_{a}+{X}_{ts}\right)}^{2}}$

Where the antenna series impedance may be *Zₐ* = *Rₐ* + *jXₐ* and the tag series impedance may be *Zₜₛ = Rₜₛ* +*jXₜₛ*.

The *ML* may be minimized, i.e. *ML =* 1, at conjugate matching. In others words, when *Rₐ* = *Rₜₛ* and *Xₐ = Xₜₛ*.

The following «match» parameter may be used hereafter to quantify the load power for a given available power: $\frac{eff}{ML} = eff ∗ \frac{4 {R}_{a} {R}_{ts}}{{\left({R}_{a}+{R}_{ts}\right)}^{2} + {\left({X}_{a}+{X}_{ts}\right)}^{2}} = \frac{{P}_{out}}{{P}_{avail}} with 0 \leq \frac{eff}{ML} \leq 1$

In a RFID tag front-end the input equivalent circuit may be a parallel of a resistance, *Rₜₚ* **904** for short, and a capacitance, *Cₜₚ* **903** for short.

The input parallel resistance may be defined by the rectifier input parallel resistance.

At the frequency *f*₀ the parallel equivalent circuit can be represented by the equivalent series circuit, *Rₜₛ* **907** and *Cₜₛ* **906,** according to the transformation formulas: ${R}_{ts} = \frac{{R}_{tp}}{1 + {Q}^{2}}$ ${C}_{ts} = {C}_{tp} \frac{1 + {Q}^{2}}{{Q}^{2}}$ $Q = 2 {πf}_{0} {C}_{tp} {R}_{tp}$

Said open loop control unit **100,** according to the present invention, may determine the rectifier output power *Pₒᵤₜ* and adjust the match parameter thus in turn controlling the rectifier input resistance *Rₜₚ* and efficiency *eff.* The match parameter may be a function of *ML,* i.e. function of *Rₜₛ* and *Rₜₚ*, and *eff.*

More precisely, the control on the rectifier input resistance and efficiency may act on a gate controller **200, 300** of a charge pump converter **500.**

Said charge pump converter **500** may have an input impedance between a first input terminal **210** and a second input terminal **310,** and a first output terminal **250,** a second output terminal **350,** a primary bias current flow controller **225,** a secondary bias current flow controller **325,** a primary attenuator controlling terminal **435** and a secondary attenuator controlling terminal **445,** as illustrated in fig.1A and 1B.

Said primary bias current flow controller **225** and said secondary bias current flow controller **325** may be configured to be plugged to said power control unit **100** and to modify input impedance, and said primary attenuator controlling terminal **435** and said secondary attenuator controlling terminal **445** may be configured to be plugged to said power control unit **100** and to modify a K-factor.

Effectively, to maximize the received power, *Pᵢₙ* **910** for short, may be a necessary but not yet enough condition to maximize the load power, i.e. the rectifier output power, *Pₒᵤₜ* **920** for short, and in order to maximize the load power it may be necessary to maximize also the rectifier efficiency, *eff **105*** for short, and the K-factor, also known as Q-factor.

The relation between the power available at the antenna, *Pₐᵥₐᵢₗ* **930** for short, and the load power, *Pₒᵤₜ* for short, being: ${P}_{out} = {P}_{avail} ∗ \frac{eff}{ML}$ where $eff = \frac{{P}_{out}}{{P}_{in}} and ML = \frac{{P}_{avail}}{{P}_{in}}$

The mismatch loss, *ML* **905** for short, can be expressed in terms of the series impedances of antenna and tag as: $\frac{1}{ML} = \frac{4 {R}_{a} {R}_{ts}}{{\left({R}_{a}+{R}_{ts}\right)}^{2} + {\left({X}_{a}+{X}_{ts}\right)}^{2}}$

Where the antenna series impedance may be *Zₐ* = *Rₐ* + *jXₐ* and the tag series impedance may be *Zₜₛ = Rₜₛ* +*jXₜₛ*.

The *ML* may be minimized, i.e. *ML =* 1, at conjugate matching. In other words, when *Rₐ* = *Rₜₛ* and *Xₐ = Xₜₛ*.

The following «match» parameter may be used hereafter to quantify the load power for a given available power: $\frac{eff}{ML} = eff ∗ \frac{4 {R}_{a} {R}_{ts}}{{\left({R}_{a}+{R}_{ts}\right)}^{2} + {\left({X}_{a}+{X}_{ts}\right)}^{2}} = \frac{{P}_{out}}{{P}_{avail}} with 0 \leq \frac{eff}{ML} \leq 1$

In a RFID tag front-end the input equivalent circuit may be a parallel of a resistance, *Rₜₚ* **904** for short, and a capacitance, *Cₜₚ* **903** for short.

The input parallel resistance may be defined by the rectifier input parallel resistance.

At the frequency *f*₀ the parallel equivalent circuit can be represented by the equivalent series circuit, *Rₜₛ* **907** and *Cₜₛ* **906,** according to the transformation formulas: ${R}_{ts} = \frac{{R}_{tp}}{1 + {Q}^{2}}$ ${C}_{ts} = {C}_{tp} \frac{1 + {Q}^{2}}{{Q}^{2}}$ $Q = 2 {πf}_{0} {C}_{tp} {R}_{tp}$

Said power control unit **100,** according to the present invention, may sense the rectifier output power *Pₒᵤₜ* and controls the match parameter thus in turn controlling the rectifier input resistance *Rₜₚ* and efficiency *eff.* The match parameter may be a function of *ML,* i.e. function of *Rₜₛ* and *Rₜₚ*, and *eff.*

More precisely, the control on the rectifier input resistance and efficiency may act on said primary bias current flow controller **225** and said secondary bias current flow controller **325,** and said primary attenuator controlling terminal **435** and said secondary attenuator controlling terminal **445** respectively of said charge pump converter **500.**

Said charge pump converter **500** may comprise at least one primary gate controller **200** and at least one secondary gate controller **300** as depicted in fig. 1. Said at least one primary gate controller **200** may comprise at least one primary signal output **250,** at least one first primary signal input **230,** at least one primary bias input **220** and at least one second primary signal input **210.**

Said at least one primary signal output **250** may be connected in series to a first circuit and/or an at least one second primary signal input **210** of a charge pump converter **500.** Indeed, said at least one second primary signal input **210** may be connected to, preferably directly connected to an at least one primary signal output **250** of a following charge pump converter **500** and/or to receive a main signal, preferably from an antenna, from an integrated circuit and/or from a charge pump converter **500,** and said at least one first primary signal input **230** may receive a first control signal and said at least one primary bias input **220** may establish a voltage value and/or a current value of said at least one primary gate controller **200.**

Further, said at least one primary gate controller **200** may comprise at least one primary switching element **240** having a primary conduction path **245** with a first primary terminal **241** and a second primary terminal **242,** and a primary gate **243** configured to control the current flowing through said primary conduction path **245:** said primary conduction path **245** may provide said at least one primary signal. By controlling, the skilled man in the art would understand that the current flowing through said primary conduction path **245** or said secondary conduction path **345** may be varied in amplitude, frequency, and/or in phase such as to be transmitted to another charge pump converter stage for instance as shown in figure 1.

Said primary gate **243** may be also connected to, preferably directly connected to said at least one first primary signal input **230** preferably via at least one primary coupling capacitor **231** and to said at least one primary bias input **220** via at least one primary bias element **221,** like at least one first primary bias current flow controller **221.** So, the charge pump converter stage allows adjusting the bias voltage of said primary gate **243** by coupling said primary gate **243** of the switching element to the output of the previous charge pump converter stage and/or said at least one bias input, which sets the DC gate's voltage reference bias.

Similarly to said at least one primary gate controller **200,** said at least one secondary gate controller **300** may comprise at least one secondary signal output **350,** at least one first secondary signal input **330,** at least one secondary bias input **320** and at least one second secondary signal input **310.** Said secondary gate **343** may be also connected to, preferably directly connected to said at least one first secondary signal input **330** preferably via at least one secondary coupling capacitor **331** and to said at least one secondary bias input **320** via at least one secondary bias element **321,** like at least one first secondary bias current flow controller **321.**

Said at least one secondary signal output **350** may be connected in series to a second circuit an at least one second secondary signal input **310** of a charge pump converter **500.** Indeed, said at least one second secondary signal input **310** may be connected to, preferably directly connected to an at least one secondary signal output **350** of a following charge pump converter **500** and/or to receive said main signal, preferably from an antenna, from an integrated circuit and/or from a charge pump converter **500,** and said at least one first secondary signal input **330** may receive a second control signal, and said at least one secondary bias input **320** may establish a voltage value and/or a current value of said at least one secondary gate controller **300.** As shown in Fig. 1B, said at least one first primary signal input **230** may be connected to, preferably directly connected to said at least one primary signal output **250** and said at least one first secondary signal input **330** may be connected to, preferably directly connected to said at least one secondary signal output **350.**

Further, said at least one secondary gate controller **300** may comprise at least one secondary switching element **340** having a secondary conduction path **345** with a first secondary terminal **341** and a second secondary terminal **342,** and a secondary gate **343** configured to control the current flowing through said secondary conduction path **345:** said secondary conduction path **345** may provide said at least one secondary signal.

Said secondary gate **343** may be also configured to be connected to, preferably directly connected to said at least one first secondary signal input **330,** via at least one secondary coupling capacitor **331,** and to said at least one secondary bias input **320.** So, the charge pump converter stage allows adjusting the bias voltage of said secondary gate **343** by coupling the said secondary gate **343** of the switching element to the output of the previous charge pump converter stage and said at least one bias input, which sets the DC gate's voltage reference bias.

In order to adjust the bias voltage of the gates **243, 343,** the gates **243, 343** of the switching elements in said at least one primary gate controller **200** and said at least one secondary gate controller **300** may be coupled to the output of the previous charge pump converter stage and/or said at least one bias input **220, 320,** which sets the DC gate's voltage reference bias. More specifically, the present invention may comprise said at least one primary gate controller **200** and said at least one secondary gate controller **300** having said primary gate **243,** said at least one primary bias input **220** connected to, preferably directly connected to said primary gate **243** through a bias element like a resistor or a transistor and said secondary gate **343,** said at least one secondary bias input **320** connected to, preferably directly connected to said secondary gate **343** through at least one primary bias element **221** and/or at least one secondary bias element **321** like a resistor or a transistor respectively such as to control the DC voltage bias of said primary gate **243** and said secondary gate **343** and therefore the conductivity of at least one primary switching element **240** and at least one secondary switching element **340** respectively. Said bias inputs, more precisely said at least one primary bias input **220** and said at least one secondary bias input **320** may be properly connected to, preferably directly connected to internal nodes of said charge pump converter **500** such that said at least one primary gate controller **200** and said at least one secondary gate controller **300** may be self-biased without using bias-reference external to the charge pump. As it may be in fig. 1B, where said at least one primary bias input **220** may be directly connected to, preferably directly connected to said at least one second primary signal input **210,** and said at least one secondary bias input **320** may be directly connected to, preferably directly connected to said at least one second secondary signal input **310.**

As previously mentioned, said bias element may be a resistor or a transistor. Indeed, said at least one primary bias input **220** may comprise at least one first primary bias current flow controller **221,** like at least one first primary bias transistor **221.** In some embodiments, said primary gate **243** may be connected to, preferably directly connected to said second primary terminal **242,** rather said at least one primary signal output **250** via an at least one second primary bias current flow controller **222** and/or at least one second primary bias transistor thus the primary conduction path **245** of the primary switching element **240** may be controlled. The same may apply for the secondary switching element **340** with at least one first secondary bias current flow controller **221,** like at least one first secondary bias transistor **221** and at least one second secondary bias current flow controller **322** like at least one second secondary bias transistor.

The applicant does not exclude the gate voltage of said primary gate **243** may be determined by configuration of said at least one first primary bias current flow controller **221,** like a resistor, and at least one second primary bias current flow controller **222,** like a resistor, forming a resistive divider and the DC primary gate voltage may be comprised between the voltage value of said at least one second primary signal input **210** and of a second primary terminal **242.** The same may apply for the secondary switching element **340.**

According to some embodiments not represented, instead of a resistor as said at least one first primary bias current flow controller **221** and/or as said at least one second primary bias current flow controller **222,** a transistor and preferably by a MOS transistor may be used such as the primary conduction path **245** of the primary switching element **240** may be controlled and may make said charge pump converter **500** programmable and more specifically said at least one primary gate controller **200** programmable. The same may apply for the secondary switching element **340.**

Further, said at least one first primary bias transistor **221** may be trimmed, via at least one impedance controlling terminal 513, such as to control the current flowing through and/or said at least one first primary bias transistor **221** and/or wherein said at least one second primary bias transistor may be trimmed, via at least one impedance controlling terminal 513, such as to control the current flowing through said at least one first primary bias transistor **221.** So, the primary conduction path **245** of the switching element **240** may be controlled which makes the charge pump converter programmable via an integrated circuit, a microcontroller and/or a processor. The same may apply for the secondary switching element **340.**

As shown in figures 1A and 1B, said at least one first primary bias transistor 221 and/or said at least one second primary bias transistor **222** may comprise at least one impedance controlling terminal 513 configured to trim the current flowing through said at least one first primary bias transistor 221 and/or said at least one second primary bias transistor **222** as aforementioned.

Thanks to the arrangements according to the invention, the conduction path of at least one primary switching element **240** and/or at least one secondary switching element **340** may be controlled which makes the charge pump converter programmable via said at least one open loop control unit **100** and more particularly via said first input impedance controlling terminal **513.**

The same may apply for said at least one first secondary bias transistor and said at least one second secondary bias transistor.

The applicant may want to have a linear control of said charge pump converter **500** programmable and more specifically said at least one primary gate controller **200** programmable a potentiometer and/or the digital potentiometer may replace said transistor and preferably said MOS transistor in linear with a controlled channel resistance. Since the plurality of primary bias transistor and secondary bias transistor may comprise at least one first primary bias transistor **221** and/or at least one second primary bias transistor **222,** the conduction path **245** of the primary switching element **240** may be linearly controlled and may make the charge pump converter programmable via said at least one open loop control unit **100.** The same may apply for the secondary switching element **340.**

Thus, for a given input power, by maximizing the output power in said charge pump converter **500** relatively constant over process and temperature variations for example, input resistance *Rₜₚ* and rectifier efficiency *eff* may be obtained.

It follows that said open loop control unit **100,** by reducing the spread of the match parameter makes the Sensitivity and the reading distance tag performance more constant and reliable across temperature and process variations.

It also follows that said open loop control unit **100,** by reducing the spread of the rectifier input resistance *Rₜₚ* makes the tag quality factor *Q* more constant over temperature and process variations enabling more consistent Sensitivity and tag reading distance performances across the UHF band.

At the resonance, i.e. when *Xₐ =* -*Xₜₛ,* it may be possible that the equivalent series resistance at resonance *Rₜₛ* matches the antenna resistance *Rₐ* minimizing the mismatch loss *ML.*

If the *Pₐᵥₐᵢₗ* may be the minimum input power at which the Tag can operate, then said open loop control unit **100** may minimize the tag Sensitivity and may maximize the tag reading distance over temperature and process variations.

Thus, using a PSBGC rectifier and said open loop control unit **100,** it may be possible to perform an automatic control of the input resistance, via at least one impedance controlling terminal **513,** and efficiency of the match parameter of the PSBGC rectifier.

In order to achieve this objective, said open loop control unit **100** may comprise at least one reference circuit **110,** and at least one control unit 120.

Said at least reference circuit **110** may comprise at least one main reference **115** configured to be constant over time and temperature, and at least one auxiliary reference **113** configured to vary over time and temperature. Thus, said at least one reference circuit **110** may be configured to sense difference between said at least one main reference **115** and said at least one auxiliary reference **113** such as to transmit a difference value **121** as a function of the temperature and/or the time. According to an embodiment, said voltage difference value **121** and/or said current difference value **121** may be transmitted as analog signal to said at least one control unit **120,** which may be quicker than digital signal.

Said at least one control unit **120** may be configured to receive said difference value **121,** to establish a trim value and to send said trim value to said impedance controlling terminal **513** such as to modify said input impedance, by controlling in amplitude, frequency, and/or in phase the current flowing through said primary conduction path **245** or said secondary conduction path **345.** Thus, said open loop control unit **100** may determine the received power and may take actions to minimize the tag sensitivity and thus may maximize the tag reading distance.

As depicted in figure 1, said reference circuit **110** may comprise said at least one main reference **115** and said at least one auxiliary reference **113.** Said at least one auxiliary reference **113** may comprise at least one first switching element **113** having first specifications and said charge pump converter **500** may comprise at least one primary switching element **240** and at least one secondary switching element **340** having second specifications. By said first specifications and said second specifications, the skilled man in the art may understand the specification comprised in a datasheet of said at least one primary switching element **240,** said at least one secondary switching element **340** and/or said at least one auxiliary reference **113** like average value of current and/or voltage, a typical value of current and/or voltage, a typical range of current and/or voltage, tolerances of current and/or voltage, and/or a nominal value of current and/or voltage for instance.

A ratio between said first specifications and said second specifications may be comprised between 0.8 and 1.25, preferably between 0.9 and 1.11. In others words, said at least one first switching element **113** may have more or less the same specifications than said at least one primary switching element **240** and at least one secondary switching element **340** such as to replicate the variation of said at least one primary switching element **240** and at least one secondary switching element **340** without using a feedback to determine said input impedance between a second primary signal input **210** and a second secondary signal input **310.** Further, since said at least one first switching element **113** may have more or less the same specifications than said at least one primary switching element **240** and at least one secondary switching element **340,** said at least one first switching element **113** may be likely to behave like said at least one primary switching element **240** and at least one secondary switching element **340** over time and/or temperature.

As depicted in figs. 1A and 1B, said at least one first switching element **113** may be a MOSFET transistor in a diode configuration and the drain of said at least one first switching element **113** may be connected to a bias current source **119.** Thus, for a given bias current through said at least one first switching element **113,** the forward bias voltage varies across temperature and process variations which may result in a variable value supplied by said at least one auxiliary reference **113.** It may be shown that, for each process and temperature, by controlling the forward bias voltage of said at least one first switching element **113,** the charge pump converter efficiency and input impedance may spread significantly less across temperature and process variations.

Said at least one first switching element **113** may also be connected to said at least one main reference **115.** As aforementioned, said at least one main reference **115** may be constant over time and temperature and may set a reference value. Said at least one reference circuit **110** may comprise at least one at least one comparison circuit **117** connected to said at least one main reference **115** and said at least one auxiliary reference **113** such as to compare said reference value to said variable value.

Said difference between said at least one main reference **115** and said at least one auxiliary reference **113** may be transmitted as a difference value **121** as a function of the temperature and/or the time.

In other words, the variation over time and temperature of charge pump converter **500** may be determined with said at least one reference circuit **110.** During the adaptation of the impedance, said at least one main reference **115** may be set such that said output value of said charge pump converter **500** may be slightly above the power-on-reset or POR value.

The analog output of said at least reference circuit **110** carries the information of the charge pump converter **500** output power, which may be converted to a digital word by said at least control unit **120,** and more specifically by at least one converter **122.** The latter, i.e. said at least one converter **122,** may be configured to convert said sensed current value and/or said sensed voltage value of said charge pump converter **500** into a digital voltage value **124** and/or a digital current value **124,** in other word, a copy of said difference value **121** may be converted to a digital word **124** by said at least one converter **122.**

Said at least control unit **120,** previously mentioned, may comprise at least one controller **123** configured to establish an established voltage value and/or an established current value as a function of said sensed current value and/or said sensed voltage value of said charge pump converter **500,** such as to find the best trim code to maximize Pout_d.

Thus, thanks to this arrangement, said open loop control unit **100** may reduce the spread of at least Input Resistance, Mismatch Loss, Quality Factor, Rectifier Efficiency and/or Match parameter over temperature and process variations.

In addition to the above advantage, if said charge pump converter **500,** which may be a rectifier, may be designed such that the tag input resistance matches the antenna resistance at the minimum input power at which the tag can operate, the Tag Sensitivity may be minimized and/or the Tag reading distance may be maximized over temperature and process variations.

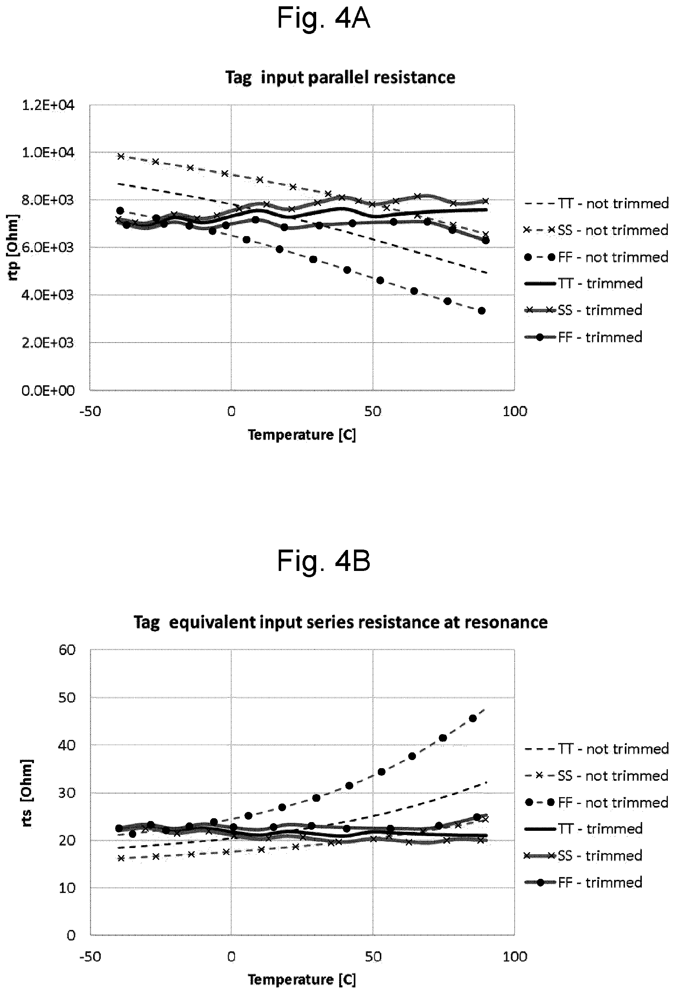

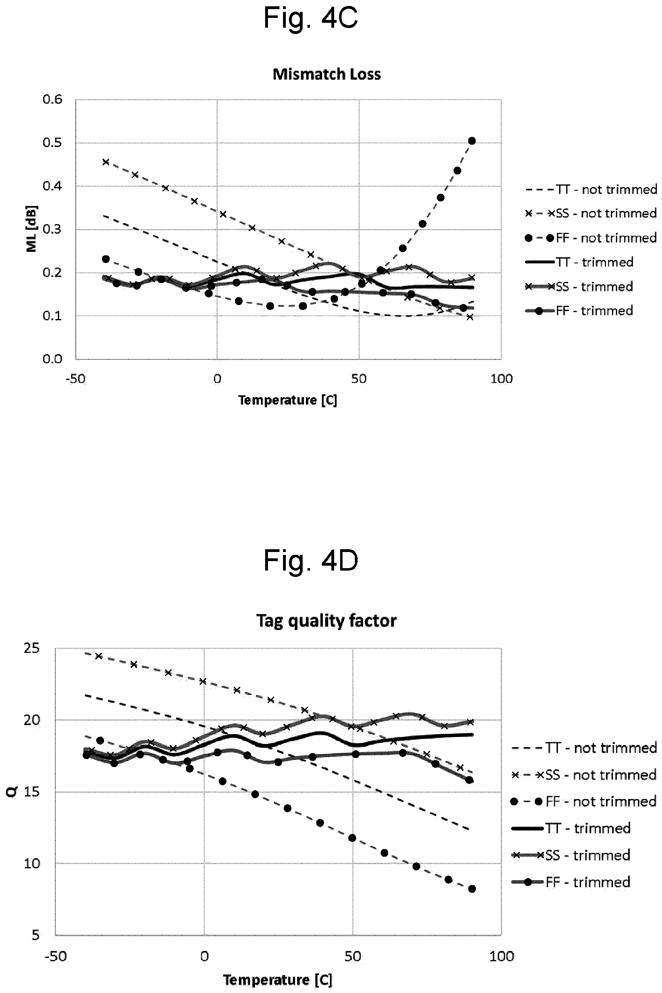

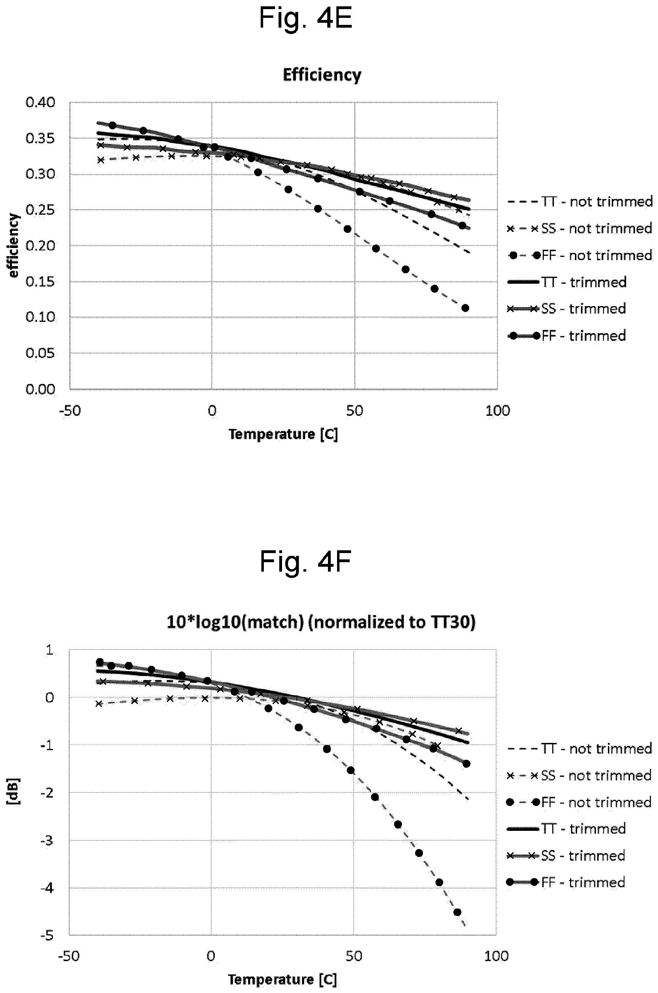

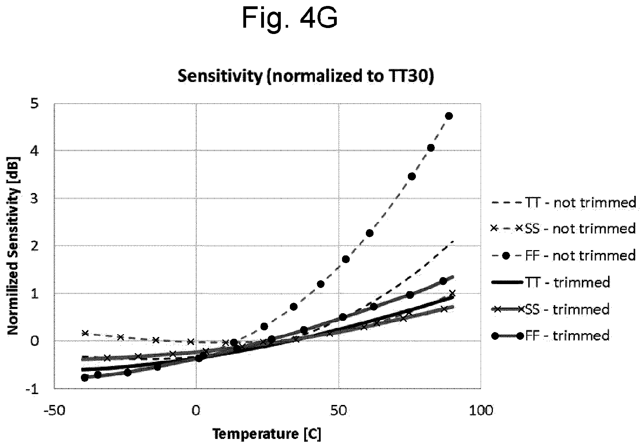

Figs. 4A-4G represent Tag input parallel resistance *Rₜₚ*, input equivalent series resistance *Rₜₛ,* Tag mismatch loss *ML* and Tag Quality Factor Q respectively, for a given input power as a function of temperature and over three process corners for a tag using an 8-stages differential Dickson charge pump with rectifier and with said open loop control unit **100.** In the not trimmed case the trim code to the rectifier may be kept fixed. In the trimmed case the trim code to the rectifier may be determined by said open loop control unit **100** control loop.

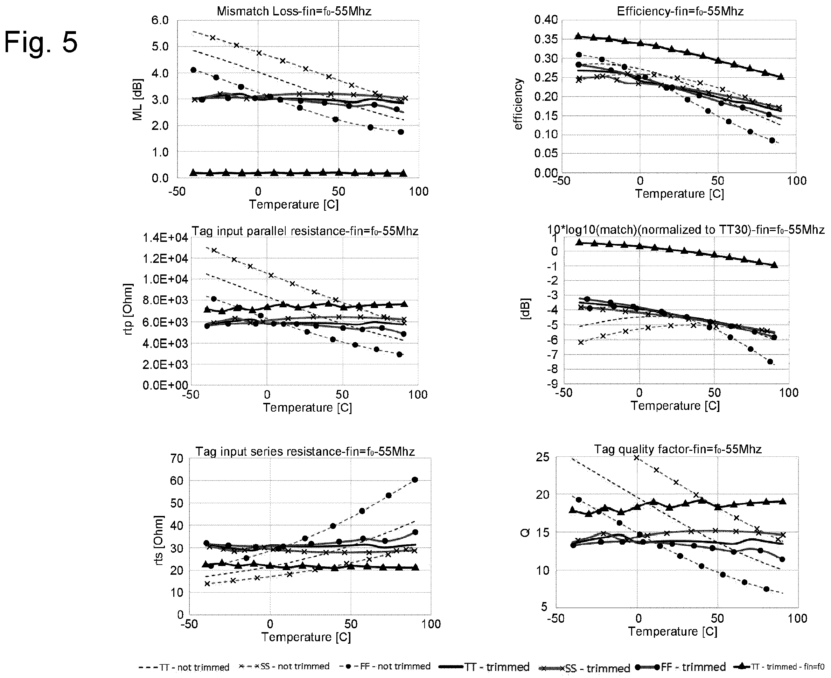

The AutoMatch tag performances may be here evaluated for a given input power at *fᵢₙ = f*₀ *- 55MHz,* see fig. 5, with a series resonant RLC antenna-tag equivalent circuit tuned at *f*₀ and with an antenna quality factor equals to 16. In all the plots the performances out of resonance may be compared with the TT-trimmed case at *fᵢₙ* = *f*₀. The «match» parameter may be maximized in all the conditions even with an input frequency out of resonance ***Xₐ** ≠ **Xₜₛ.***

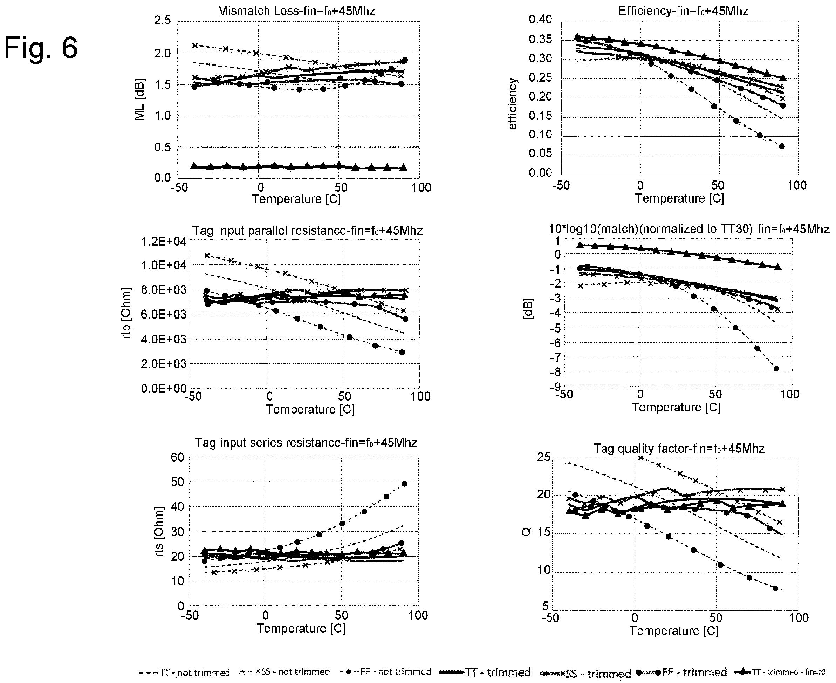

In fig. 6, the AutoMatch tag performances may be evaluated for a given input power at *fᵢₙ = f*₀ *+ 45MHz* with a series resonant RLC antenna-tag equivalent circuit tuned at f0and with an antenna quality factor equals to 16. In all the plots the performances out of resonance may be compared with the TT-trimmed case at *fᵢₙ* = *f*₀. The «match» parameter may be maximized in all the conditions even with an input frequency out of resonance ***Xₐ** ≠ **Xₜₛ**.*

## Claims

1. Control system device (600) comprising at least one open loop control unit (100) and at least one charge pump converter (500), said open loop control unit (100) being configured to control the efficiency and/or the input impedance of said at least one charge pump converter (500), wherein said at least one charge pump converter comprises an input impedance, and a first input impedance controlling terminal (513); said open loop control unit (100) comprising at least one:
- reference circuit (110) comprising at least one main reference (115) configured to be constant over time and temperature, and at least one auxiliary reference (113) configured to vary over time and temperature; said reference circuit (110) being configured to sense difference between said main reference (115) and said auxiliary reference (113) such as to transmit a difference value (121) as a function of the temperature and/or the time;
- control unit (120) being configured to receive said difference value (121), to establish a trim value and to send said trim value to said first input impedance controlling terminal (513) such as to modify said input impedance,
- wherein said first input impedance controlling terminal (513) is configured to be plugged to said open loop control unit (100) and to modify said input impedance according to a signal from said open loop control unit (100), in that said charge pump converter (500) comprises at least one primary gate controller (200) having at least one primary switching element (240) with first specifications and at least one secondary gate controller (300) having at least one secondary switching element (340) with second specifications, in that the primary gate controller (200) comprises primary bias input (220) having a primary bias current flow controller (225) and in that the secondary gate controller (300) comprises a secondary bias input (320) having a secondary bias current flow controller (325); said primary bias current flow controller (225) and said secondary bias current flow controller (325) being configured to be plugged to said open loop control unit (100) to receive said trim value via the first input impedance controlling terminal (513) and to modify the input impedance.

2. Control system device (600) according to claim 1, wherein said difference value (121) comprises a voltage difference value (121) and/or current difference value (121).

3. Control system device (600) according to claim 1 or 2, wherein said auxiliary reference (113) comprises at least one first switching element (113) having first specifications and wherein a ratio between said first specifications and said second specifications is comprised between 0.8 and 1.25, preferably between 0.9 and 1.11.

4. Control system device (600) according to claim 3, wherein said first specifications and said second specification may be configured to vary over time and temperature.

5. Control system device (600) according to any preceding claims, wherein said at least one main reference (115) may be configured to set a reference value and said at least one auxiliary reference (113) may be configured to supply a variable value; said reference value may be constant over time and temperature and said variable value varies over time and temperature.

6. Control system device (600) according to any preceding claims, wherein said at least one reference circuit (110) comprises at least one comparison circuit (117) configured to compare said reference value to said variable value.

7. Control system device (600) according to any preceding claims, wherein said at least control unit (120) comprises at least one controller (123) configured to establish an established voltage value and/or an established current value as a function of said difference between said at least one main reference (115) and said at least one auxiliary reference (113).

8. Control system device (600) according to any preceding claims, wherein said at least bias supplier (120) comprises at least one converter (122) configured to convert said difference between said at least one main reference (115) and said at least one auxiliary reference (113) into a digital voltage value and/or a digital current value.

9. Control system device (600) according to any preceding claims wherein said at least one primary gate controller (200) comprises at least one;
- primary signal output (250): said at least one primary signal output (250) is configured to be connected to an at least one second primary signal input (210) of a charge pump converter stage (500) and/or a first circuit;
- first primary signal input (230): said at least one first primary signal input (230) is configured to receive a first control signal;
- primary bias input (220): said at least one primary bias input (220) configured to establish a voltage value and/or a current value of said at least one primary gate controller (200);
- second primary signal input (210): said at least one second primary signal input (210) configured to be connected to an at least one primary signal output (250) of a charge pump converter stage (500) and/or to receive said main signal, preferably from an antenna, from an integrated circuit, at least one primary signal and/or from a charge pump converter stage (500); and,
said at least one secondary gate controller (300) comprises at least one:
- secondary signal output (350): said at least one secondary signal output (350) is configured to be connected to an at least one second secondary signal input (310) of a charge pump converter stage (500) and/or a second circuit;
- first secondary signal input (330): said at least one first secondary signal input (330) is configured to receive a second control signal;
- secondary bias input (320): at least one secondary bias input (320) configured to establish a voltage value and/or a current value of said at least one secondary gate controller (300); and,
- second secondary signal input (310): said at least one second secondary signal input (310) configured to be connected to an at least one secondary signal output (350) of a charge pump converter stage (500) and/or to receive a main signal, preferably from an antenna, from an integrated circuit, at least one secondary signal and/or from a charge pump converter stage (500);
said at least one first primary signal input (230) is configured to be connected to said at least one secondary signal output (350) and said at least one first secondary signal input (330) is configured to be connected to said at least one primary signal output (250).

10. Control system device (600) according to claim 9, wherein said at least one primary switching element (240) has a primary conduction path (245) with a first primary terminal (241) and a second primary terminal (242), and a primary gate (243) configured to control the current flowing through said primary conduction path (245), said primary conduction path (245) being configured to provide said at least one primary signal; said primary gate (243) is configured to be connected to said at least one first primary signal input (230) and to said at least one primary bias input (220), and wherein said secondary switching element (340) has a secondary conduction path (345) with a first secondary terminal (341) and a second secondary terminal (342), and a secondary gate (343) configured to control the current flowing through said secondary conduction path (345), said secondary conduction path (345) being configured to provide said at least one secondary signal; said secondary gate (343) is configured to be connected to said at least one first secondary signal input (330) and to said at least one secondary bias input (320).

11. Control system device (600) according to any one of claims 9 and 10, wherein said primary bias current flow controller (225) comprises:
• a first primary bias element (221) chosen among a transistor or a resistor;
• and a second primary bias transistor (222);
and wherein said secondary bias current flow controller (325) comprises:
• a first secondary bias element (321) chosen among a transistor or a resistor;
• and a second secondary bias transistor (322).

12. Control system device (600) according to any one of claims 9 to 11, wherein said at least one charge pump converter (500) comprises at least one first input impedance controlling terminal (513) configured to be plugged to said open loop control unit (100) such as to modify said input impedance.

## Patentansprüche

1. Steuersystemvorrichtung (600), die mindestens eine Steuereinheit (100) im offenen Regelkreis und mindestens einen Ladungspumpenwandler (500) umfasst, wobei die Steuereinheit (100) im offenen Regelkreis eingerichtet ist, den Wirkungsgrad und/oder die Eingangsimpedanz des mindestens einen Ladungspumpenwandlers (500) zu steuern, wobei der mindestens eine Ladungspumpenwandler eine Eingangsimpedanz und einen ersten Eingangsimpedanzsteueranschluss (513) umfasst; wobei die Steuereinheit (100) im offenen Regelkreis mindestens eines der folgenden umfasst:
- Referenzschaltung (110), umfassend mindestens eine Hauptreferenz (115), die so eingerichtet ist, dass sie über Zeit und Temperatur konstant ist, und mindestens eine Hilfsreferenz (113), die so eingerichtet ist, dass sie über Zeit und Temperatur variiert; wobei die Referenzschaltung (110) so eingerichtet ist, dass sie eine Differenz zwischen der Hauptreferenz (115) und der Hilfsreferenz (113) erfasst, um einen Differenzwert (121) in Abhängigkeit von der Temperatur und/oder der Zeit zu übertragen;
- Steuereinheit (120), die so eingerichtet ist, dass sie den Differenzwert (121) empfängt, einen Abgleichwert festlegt und den Abgleichwert an den ersten Eingangsimpedanzsteueranschluss (513) sendet, um die Eingangsimpedanz zu modifizieren,
- wobei der erste Eingangsimpedanzsteueranschluss (513) so eingerichtet ist, dass er an die Steuereinheit (100) im offenen Regelkreis angeschlossen wird und die Eingangsimpedanz gemäß einem Signal von der Steuereinheit (100) im offenen Regelkreis modifiziert, dadurch dass der Ladungspumpenwandler (500) mindestens eine primäre Gate-Steuerung (200) mit mindestens einem primären Schaltelement (240) mit ersten Spezifikationen und mindestens eine sekundäre Gate-Steuerung (300) mit mindestens einem sekundären Schaltelement (340) mit zweiten Spezifikationen umfasst, dadurch dass die primäre Gate-Steuerung (200) einen primären Vorspannungseingang (220) mit einer primären Vorspannungsstromflusssteuerung (225) umfasst und dadurch dass die sekundäre Gate-Steuerung (300) einen sekundären Vorspannungseingang (320) mit einer sekundären Vorspannungsstromflusssteuerung (325) umfasst;
wobei die primäre Vorspannungsstromflusssteuerung (225) und die sekundäre Vorspannungsstromflusssteuerung (325) so eingerichtet sind, dass sie an die Steuereinheit (100) im offenen Regelkreis angeschlossen werden können, um den Abgleichwert über den ersten Eingangsimpedanzsteueranschluss (513) zu empfangen und die Eingangsimpedanz zu modifizieren.

2. Steuersystemvorrichtung (600) nach Anspruch 1, wobei der Differenzwert (121) einen Spannungsdifferenzwert (121) und/oder einen Stromdifferenzwert (121) umfasst.

3. Steuersystemvorrichtung (600) nach Anspruch 1 oder 2, wobei die Hilfsreferenz (113) mindestens ein erstes Schaltelement (113) mit ersten Spezifikationen umfasst und wobei ein Verhältnis zwischen den ersten Spezifikationen und den zweiten Spezifikationen zwischen 0,8 und 1,25, vorzugsweise zwischen 0,9 und 1,11 beträgt.

4. Steuersystemvorrichtung (600) nach Anspruch 3, wobei die ersten Spezifikationen und die zweite Spezifikation so eingerichtet sein können, dass sie sich über Zeit und Temperatur ändern.

5. Steuersystemvorrichtung (600) nach einem der vorhergehenden Ansprüche, wobei die mindestens eine Hauptreferenz (115) eingerichtet sein kann, einen Referenzwert festzulegen, und die mindestens eine Hilfsreferenz (113) eingerichtet sein kann, einen variablen Wert zu liefern; wobei der Referenzwert über Zeit und Temperatur konstant sein kann und der variable Wert über Zeit und Temperatur variiert.

6. Steuersystemvorrichtung (600) nach einem der vorhergehenden Ansprüche, wobei die mindestens eine Referenzschaltung (110) mindestens eine Vergleichsschaltung (117) umfasst, die eingerichtet ist, den Referenzwert mit dem variablen Wert zu vergleichen.

7. Steuersystemvorrichtung (600) nach einem der vorhergehenden Ansprüche, wobei die mindestens eine Steuereinheit (120) mindestens einen Regler (123) umfasst, der eingerichtet ist, einen festgelegten Spannungswert und/oder einen festgelegten Stromwert in Abhängigkeit von der Differenz zwischen der mindestens einen Hauptreferenz (115) und der mindestens einen Hilfsreferenz (113) festzulegen.

8. Steuersystemvorrichtung (600) nach einem der vorhergehenden Ansprüche, wobei die mindestens eine Vorspannungsversorgung (120) mindestens einen Wandler (122) umfasst, der eingerichtet ist, die Differenz zwischen der mindestens einen Hauptreferenz (115) und der mindestens einen Hilfsreferenz (113) in einen digitalen Spannungswert und/oder einen digitalen Stromwert umzuwandeln.

9. Steuersystemvorrichtung (600) nach einem der vorhergehenden Ansprüche, wobei die mindestens eine primäre Gate-Steuerung (200) mindestens eines der fogenden umfasst;
- primären Signalausgang (250): der mindestens eine primäre Signalausgang (250) ist dazu eingerichtet, mit einem mindestens einen zweiten primären Signaleingang (210) einer Ladungspumpenwandlerstufe (500) und/oder einer ersten Schaltung verbunden zu sein;
- ersten primären Signaleingang (230): der mindestens eine erste primäre Signaleingang (230) ist dazu eingerichtet, ein erstes Steuersignal zu empfangen;
- primären Vorspannungseingang (220): der mindestens eine primäre Vorspannungseingang (220) ist dazu eingerichtet, einen Spannungswert und/oder einen Stromwert der mindestens einen primären Gate-Steuerung (200) festzulegen;
- zweiten primären Signaleingang (210): der mindestens eine zweite primäre Signaleingang (210) ist dazu eingerichtet, mit einem mindestens einen primären Signalausgang (250) einer Ladungspumpenwandlerstufe (500) verbunden zu sein und/oder das Hauptsignal, bevorzugt von einer Antenne, von einer integrierten Schaltung, mindestens einem primären Signal und/oder von einer Ladungspumpenwandlerstufe (500) zu empfangen; und
die mindestens eine sekundäre Gate-Steuerung (300) umfasst mindestens einen:
- sekundären Signalausgang (350): der mindestens eine sekundäre Signalausgang (350) ist dazu eingerichtet, mit einem mindestens einen zweiten sekundären Signaleingang (310) einer Ladungspumpenwandlerstufe (500) und/oder einer zweiten Schaltung verbunden zu sein;
- ersten sekundären Signaleingang (330): der mindestens eine erste sekundäre Signaleingang (330) ist dazu eingerichtet, ein zweites Steuersignal zu empfangen;
- sekundären Vorspannungseingang (320): mindestens ein sekundärer Vorspannungseingang (320) ist dazu eingerichtet, einen Spannungswert und/oder einen Stromwert der mindestens einen sekundären Gate-Steuerung (300) festzulegen; und
- zweiten sekundären Signaleingang (310): der mindestens eine zweite sekundäre Signaleingang (310) ist dazu eingerichtet, mit einem mindestens einen sekundären Signalausgang (350) einer Ladungspumpenwandlerstufe (500) verbunden zu sein und/oder ein Hauptsignal, bevorzugt von einer Antenne, von einer integrierten Schaltung, mindestens einem sekundären Signal und/oder von einer Ladungspumpenwandlerstufe (500) zu empfangen;
der mindestens eine erste primäre Signaleingang (230) ist dazu eingerichtet, mit dem mindestens einen sekundären Signalausgang (350) verbunden zu sein, und der mindestens eine erste sekundäre Signaleingang (330) ist dazu eingerichtet, mit dem mindestens einen primären Signalausgang (250) verbunden zu sein.

10. Steuersystemvorrichtung (600) nach Anspruch 9, wobei das mindestens eine primäre Schaltelement (240) einen primären Leitungsweg (245) mit einem ersten primären Anschluss (241) und einem zweiten primären Anschluss (242) aufweist, und ein primäres Gate (243), das dazu eingerichtet ist, den durch den primären Leitungsweg (245) fließenden Strom zu steuern, der primäre Leitungsweg (245) dazu eingerichtet ist, das mindestens eine primäre Signal bereitzustellen; das primäre Gate (243) dazu eingerichtet ist, mit dem mindestens einen ersten primären Signaleingang (230) und mit dem mindestens einen primären Vorspannungseingang (220) verbunden zu sein, und wobei das mindestens eine sekundäre Schaltelement (340) einen sekundären Leitungsweg (345) mit einem ersten sekundären Anschluss (341) und einem zweiten sekundären Anschluss (342) aufweist, und ein sekundäres Gate (343), das dazu eingerichtet ist, den durch den sekundären Leitungsweg (345) fließenden Strom zu steuern, wobei der sekundäre Leitungsweg (345) dazu eingerichtet ist, das mindestens eine sekundäre Signal bereitzustellen; wobei das sekundäre Gate (343) dazu eingerichtet ist, mit dem mindestens einen ersten sekundären Signaleingang (330) und mit dem mindestens einen sekundären Vorspannungseingang (320) verbunden zu sein.

11. Steuersystemvorrichtung (600) nach einem der Ansprüche 9 und 10, wobei die primäre Vorspannungsstromflusssteuerung (225) umfasst:
• ein erstes primäres Vorspannungselement (221), ausgewählt aus einem Transistor oder einem Widerstand;
• und einen zweiten primären Vorspannungstransistor (222); und wobei die sekundäre Vorspannungsstromflusssteuerung (325) umfasst:
• ein erstes sekundäres Vorspannungselement (321), das aus einem Transistor oder einem Widerstand ausgewählt ist;
• und einen zweiten sekundären Vorspannungstransistor (322).

12. Steuersystemvorrichtung (600) nach einem der Ansprüche 9 bis 11, wobei der mindestens eine Ladungspumpenwandler (500) mindestens einen ersten Eingangsimpedanzsteueranschluss (513) umfasst, der dazu eingerichtet ist, an die Steuereinheit (100) mit offenem Regelkreis angeschlossen zu werden, um dadurch die Eingangsimpedanz zu verändern.

## Revendications

1. Dispositif de système de commande (600) comprenant au moins une unité de commande en boucle ouverte (100) et au moins un convertisseur à pompe de charge (500), ladite unité de commande en boucle ouverte (100) étant configurée pour commander le rendement et/ou l'impédance d'entrée dudit au moins un convertisseur à pompe de charge (500), dans lequel ledit au moins un convertisseur à pompe de charge comprend une impédance d'entrée, et une première borne de commande d'impédance d'entrée (513) ; ladite unité de commande en boucle ouverte (100) comprenant au moins un(e) :
- circuit de référence (110) comprenant au moins une référence principale (115) configurée pour être constante par rapport au temps et à la température, et au moins une référence auxiliaire (113) configurée pour varier par rapport au temps et à la température ; ledit circuit de référence (110) étant configuré pour capter une différence entre ladite référence principale (115) et ladite référence auxiliaire (113) de façon à transmettre une valeur de différence (121) en fonction de la température et/ou du temps ;
- unité de commande (120) étant configurée pour recevoir ladite valeur de différence (121), pour établir une valeur d'ajustement et pour envoyer ladite valeur d'ajustement à ladite première borne de commande d'impédance d'entrée (513) de façon à modifier ladite impédance d'entrée,
- dans lequel ladite première borne de commande d'impédance d'entrée (513) est configurée pour être branchée à ladite unité de commande en boucle ouverte (100) et pour modifier ladite impédance d'entrée conformément à un signal provenant de ladite unité de commande en boucle ouverte (100), en ce que ledit convertisseur à pompe de charge (500) comprend au moins un dispositif de commande de grille primaire (200) ayant au moins un élément de commutation primaire (240) ayant des premières spécifications et au moins un dispositif de commande de grille secondaire (300) ayant un élément de commutation secondaire (340) ayant des secondes spécifications, en ce que le dispositif de commande de grille primaire (200) comprend une entrée de polarisation primaire (220) ayant un dispositif de commande de circulation de courant de polarisation primaire (225) et en ce que le dispositif de commande de grille secondaire (300) comprend une entrée de polarisation secondaire (320) ayant un dispositif de commande de circulation de courant de polarisation secondaire (325) ;
ledit dispositif de commande de circulation de courant de polarisation primaire (225) et ledit dispositif de commande de circulation de courant de polarisation secondaire (325) étant configurés pour être branchés à ladite unité de commande en boucle ouverte (100) pour recevoir ladite valeur d'ajustement par l'intermédiaire de la première borne de commande d'impédance d'entrée (513) et pour modifier l'impédance d'entrée.

2. Dispositif de système de commande (600) selon la revendication 1, dans lequel ladite valeur de différence (121) comprend une valeur de différence de tension (121) et/ou une valeur de différence de courant (121).

3. Dispositif de système de commande (600) selon la revendication 1 ou 2, dans lequel ladite référence auxiliaire (113) comprend au moins un premier élément de commutation (113) ayant des premières spécifications et dans lequel un rapport entre lesdites premières spécifications et lesdites secondes spécifications est compris entre 0,8 et 1,25, de préférence entre 0,9 et 1,11.

4. Dispositif de système de commande (600) selon la revendication 3, dans lequel lesdites premières spécifications et ladite seconde spécification peuvent être configurées pour varier par rapport au temps et à la température.

5. Dispositif de système de commande (600) selon l'une quelconque des revendications précédentes, dans lequel ladite au moins une référence principale (115) peut être configurée pour définir une valeur de référence et ladite au moins une référence auxiliaire (113) peut être configurée pour fournir une valeur variable ; ladite valeur de référence peut être constante par rapport au temps et à la température et ladite valeur variable varie par rapport au temps et à la température.

6. Dispositif de système de commande (600) selon l'une quelconque des revendications précédentes, dans lequel ledit au moins un circuit de référence (110) comprend au moins un circuit de comparaison (117) configuré pour comparer ladite valeur de référence à ladite valeur variable.

7. Dispositif de système de commande (600) selon l'une quelconque des revendications précédentes, dans lequel ladite au moins une unité de commande (120) comprend au moins un dispositif de commande (123) configuré pour établir une valeur de tension établie et/ou une valeur de courant établie en fonction de ladite différence entre ladite au moins une référence principale (115) et ladite au moins une référence auxiliaire (113).

8. Dispositif de système de commande (600) selon l'une quelconque des revendications précédentes, dans lequel ledit au moins un fournisseur de polarisation (120) comprend au moins un convertisseur (122) configuré pour convertir ladite différence entre ladite au moins une référence principale (115) et ladite au moins une référence auxiliaire (113) en une valeur de tension numérique et/ou une valeur de courant numérique.

9. Dispositif de système de commande (600) selon l'une quelconque des revendications précédentes, dans lequel ledit au moins un dispositif de commande de grille primaire (200) comprend au moins une ;
- sortie de signal primaire (250) : ladite au moins une sortie de signal primaire (250) est configurée pour être connectée à au moins une seconde entrée de signal primaire (210) d'un étage de convertisseur à pompe de charge (500) et/ou un premier circuit ;
- première entrée de signal primaire (230) : ladite au moins une première entrée de signal primaire (230) est configurée pour recevoir un premier signal de commande ;
- entrée de polarisation primaire (220) : ladite au moins une entrée de polarisation primaire (220) étant configurée pour établir une valeur de tension et/ou une valeur de courant dudit au moins un dispositif de commande de grille primaire (200) ;
- seconde entrée de signal primaire (210) : ladite au moins une seconde entrée de signal primaire (210) étant configurée pour être connectée à au moins une sortie de signal primaire (250) d'un étage de convertisseur à pompe de charge (500) et/ou pour recevoir ledit signal principal, de préférence provenant d'une antenne, provenant d'un circuit intégré, au moins un signal primaire et/ou provenant d'un étage de convertisseur à pompe de charge (500) ; et,
ledit au moins un dispositif de commande de grille secondaire (300) comprend au moins une :
- sortie de signal secondaire (350) : ladite au moins une sortie de signal secondaire (350) est configurée pour être connectée à au moins une seconde entrée de signal secondaire (310) d'un étage de convertisseur à pompe de charge (500) et/ou un second circuit ;
- première entrée de signal secondaire (330) : ladite au moins une première entrée de signal secondaire (330) est configurée pour recevoir un second signal de commande ;
- entrée de polarisation secondaire (320) : au moins une entrée de polarisation secondaire (320) étant configurée pour établir une valeur de tension et/ou une valeur de courant dudit au moins un dispositif de commande de grille secondaire (300) ; et,
- seconde entrée de signal secondaire (310) : ladite au moins une seconde entrée de signal secondaire (310) étant configurée pour être connectée à au moins une sortie de signal secondaire (350) d'un étage de convertisseur à pompe de charge (500) et/ou pour recevoir un signal principal, de préférence provenant d'une antenne, provenant d'un circuit intégré, au moins un signal secondaire et/ou provenant d'un étage de convertisseur à pompe de charge (500) ;
ladite au moins une première entrée de signal primaire (230) est configurée pour être connectée à ladite au moins une sortie de signal secondaire (350) et ladite au moins une première entrée de signal secondaire (330) est configurée pour être connectée à ladite au moins une sortie de signal primaire (250).

10. Dispositif de système de commande (600) selon la revendication 9, dans lequel ledit au moins un élément de commutation primaire (240) a un trajet de conduction primaire (245) avec une première borne primaire (241) et une seconde borne primaire (242), et une grille primaire (243) configurée pour commander le courant circulant sur ledit trajet de conduction primaire (245), ledit trajet de conduction primaire (245) étant configurée pour fournir ledit au moins un signal primaire ; ladite grille primaire (243) est configurée pour être connectée à ladite au moins une première entrée de signal primaire (230) et à ladite au moins une entrée de polarisation primaire (220), et dans lequel ledit élément de commutation secondaire (340) a un trajet de conduction secondaire (345) avec une première borne secondaire (341) et une seconde borne secondaire (342), et une grille secondaire (343) configurée pour commander le courant circulant sur ledit trajet de conduction secondaire (345), ledit trajet de conduction secondaire (345) étant configurée pour fournir ledit au moins un signal secondaire ; ladite grille secondaire (343) est configurée pour être connectée à ladite au moins une première entrée de signal secondaire (330) et à ladite au moins une entrée de polarisation secondaire (320).

11. Dispositif de système de commande (600) selon l'une quelconque des revendications 9 et 10, dans lequel ledit dispositif de commande de circulation de courant de polarisation primaire (225) comprend :
• un premier élément de polarisation primaire (221) choisi parmi un transistor ou une résistance ;
• et un second transistor de polarisation primaire (222) ;
et dans lequel ledit dispositif de commande de circulation de courant de polarisation secondaire (325) comprend :
• un premier élément de polarisation secondaire (321) choisi parmi un transistor ou une résistance ;
• et un second transistor de polarisation secondaire (322).

12. Dispositif de système de commande (600) selon l'une quelconque des revendications 9 à 11, dans lequel ledit au moins un convertisseur à pompe de charge (500) comprend au moins une première borne de commande d'impédance d'entrée (513) configurée pour être branchée à ladite unité de commande en boucle ouverte (100) de façon à modifier ladite impédance d'entrée.
